(19) **Europäisches Patentamt / European Patent Office / Office européen des brevets**

(11) **EP 1 882 907 B1**

(12) **FASCICULE DE BREVET EUROPEEN**

(45) Date de publication et mention
de la délivrance du brevet:
**09.02.2011 Bulletin 2011/06**

(51) Int Cl.:
*G01D 5/244* $^{(2006.01)}$    *G01D 5/245* $^{(2006.01)}$
*G01D 5/14* $^{(2006.01)}$

(21) Numéro de dépôt: **07290861.9**

(22) Date de dépôt: **09.07.2007**

(54) **Procédé de détermination de deux signaux en quadrature**

Verfahren zur Bestimmung zweier um 90 Grad phasenverschobener Signale

Method for the determination of two signals in quadrature

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **27.07.2006 FR 0606909**

(43) Date de publication de la demande:
**30.01.2008 Bulletin 2008/05**

(73) Titulaire: **S.N.R. ROULEMENTS**
**74000 Annecy (FR)**

(72) Inventeurs:
• **Desbiolles, Pascal**
**72570 Thorens Glieres (FR)**
• **Duret, Christophe**
**74600 Quintal (FR)**

(74) Mandataire: **Sayettat, Julien Christian**
**STRATO-IP**
**18, rue Soleillet**
**75020 Paris (FR)**

(56) Documents cités:
**WO-A-99/17082      DE-A1- 4 411 808**
**FR-A1- 2 792 403**

**Description**

L'invention concerne un procédé de détermination de deux signaux pseudo sinusoïdaux en quadrature à partir d'un signal pseudo sinusoïdal émis par un codeur, un système de détermination par mise en oeuvre d'un tel procédé, ainsi qu'un palier comprenant un tel système de détermination.

L'invention s'applique en particulier au domaine de la détermination d'une donnée angulaire, telle que la position ou la vitesse, d'un organe tournant par rapport à un organe fixe.

En effet, dans une telle application, il est nécessaire de pouvoir bénéficier de deux signaux pseudo sinusoïdaux en quadrature qui sont représentatifs de la position angulaire de l'organe tournant par rapport à l'organe fixe.

Pour ce faire, on connaît du document FR-A1-2 792 403, l'utilisation d'un codeur apte à émettre un signal pseudo sinusoïdal et un capteur comprenant au moins quatre éléments sensibles qui sont linéairement équirépartis, lesdits éléments sensibles étant aptes à délivrer chacun un signal $S_i$ représentatif du signal émis par le codeur. Pour former les deux signaux en quadrature, ce document prévoit de combiner les signaux $S_i$ pour former les signaux $U = (S_1 - S_2) - (S_3 - S_4)$ et $V = (S_1 + S_2) - (S_3 + S_4)$.

Cette réalisation, notamment lorsqu'elle est mise en oeuvre avec un codeur multipolaire délivrant un signal magnétique, présente de nombreux avantages en ce qu'elle permet :

- de conserver les signaux U et V en quadrature pour plusieurs longueurs polaires du codeur ;
- pour une longueur polaire donnée, d'obtenir des signaux U et V de même amplitude, par réglage des gains du conditionnement correspondant à l'amplification des signaux U ou V ;
- de supprimer les offsets magnétiques.

En revanche, dans certaines conditions de fonctionnement particulières, cette réalisation peut présenter certaines limitations relativement au positionnement des éléments sensibles par rapport au codeur.

Par exemple, l'égalité des amplitudes des signaux U et V peut être affectée par:

- une excentration du codeur par rapport à son axe de rotation qui fait que les éléments sensibles détectent des pôles de longueur polaire variable sur un tour ;
- la présence de pôles de longueur différente sur le codeur, que cette présence soit due à un défaut d'aimantation ou à une configuration souhaitée ;
- l'application d'un gain qui n'est pas parfaitement adapté à la longueur polaire du codeur.

En outre, la quadrature des signaux U et V peut être affectée lorsque la droite passant par l'ensemble des éléments sensibles n'est pas parfaitement parallèle au plan du codeur (tilt du capteur). Ce phénomène est d'autant plus critique que l'amplitude du champ magnétique varie de façon exponentielle en fonction de la distance entre le codeur et l'élément sensible.

Enfin, dans le cas où les éléments sensibles ne sont pas disposés suivant la tangente au rayon de lecture (twist du capteur), les deux phénomènes décrits ci-dessus se combinent, à savoir :

- la longueur polaire vue par chacun des éléments sensibles est différente ;
- l'amplitude du champ magnétique lu par les éléments sensibles n'est pas la même, du fait des effets de bords sur le signal délivré.

L'invention a pour but de pallier ces inconvénients en proposant notamment un conditionnement des signaux issus des éléments sensibles qui présente, relativement à la quadrature et à l'égalité des amplitudes, une fiabilité plus importante des signaux délivrés en fonction du positionnement des éléments sensibles par rapport au codeur ainsi qu'aux éventuels défauts de réalisation du codeur.

A cet effet, et selon un premier aspect, l'invention propose un procédé de détermination de deux signaux pseudo sinusoïdaux en quadrature à partir d'un signal pseudo sinusoïdal émis par un codeur, ledit procédé utilisant un capteur disposé à distance de lecture dudit codeur, ledit capteur comprenant au moins quatre éléments sensibles qui sont linéairement équirépartis, lesdits éléments sensibles étant aptes à délivrer chacun un signal $S_i$ représentatif du signal émis par le codeur, ledit procédé prévoyant de mesurer les signaux $S_i$ et de combiner lesdits signaux $S_i$ pour former les signaux $U = (S_1 - S_2) - (S_3 - S_4)$ et $V = (S_2 - S_3)$, lesdits signaux U et V étant en quadrature.

Selon un deuxième aspect, l'invention propose un système de détermination, par mise en oeuvre d'un tel procédé, de deux signaux pseudo sinusoïdaux en quadrature à partir d'un signal pseudo sinusoïdal, ledit système comprenant un codeur apte à émettre le signal et un capteur comprenant au moins quatre éléments sensibles qui sont linéairement équirépartis, lesdits éléments sensibles étant aptes à délivrer chacun un signal $S_i$ représentatif du signal émis par le codeur, ledit système comprenant en outre un dispositif de traitement qui est apte à former les signaux $S_i$

et à combiner lesdits signaux $S_i$ pour former les signaux U et V.

Selon un troisième aspect, l'invention propose un palier équipé d'un tel système de détermination, ledit palier comprenant un organe fixe et un organe tournant, dans lequel le codeur est solidarisé à l'organe tournant et le capteur est solidarisé à l'organe fixe de sorte que les éléments sensibles soient disposés à distance de lecture du signal émis par le codeur.

D'autres particularités et avantages de l'invention apparaîtront dans la description qui suit, faite en référence aux figures jointes dans lesquelles :

- la figure 1 est une représentation partielle en vue de dessus du codeur et du capteur d'un système de détermination selon un mode de réalisation de l'invention ;
- la figure 2 est une représentation schématique de la disposition des éléments sensibles dans le capteur de la figure 1 ;
- la figure 3 représente la fonction de transfert des signaux U et V selon l'invention par rapport aux signaux U et W selon l'art antérieur ;
- la figure 4 est une représentation schématique en coupe longitudinale d'un roulement équipé d'un système de détermination selon l'invention.

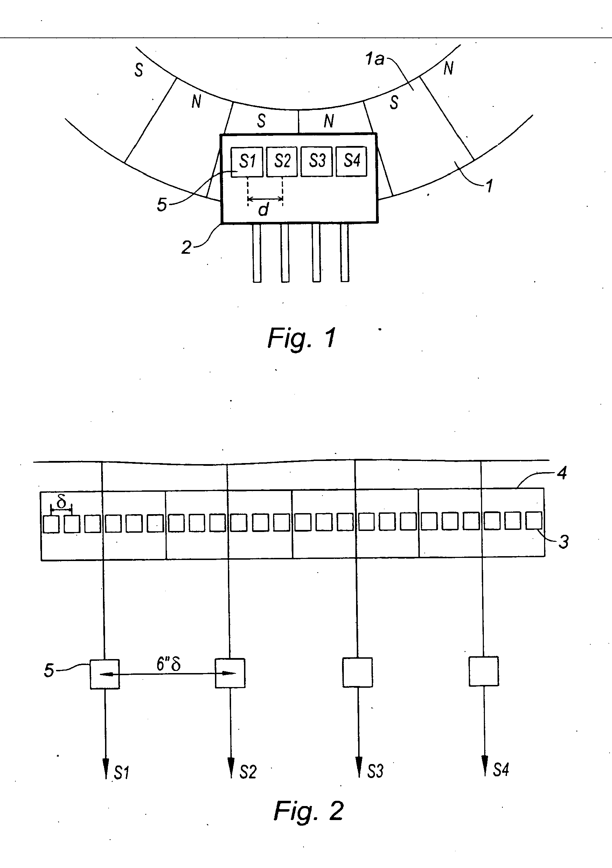

En relation avec les figures 1 et 2, on décrit un mode de réalisation d'un système de détermination de deux signaux pseudo sinusoïdaux en quadrature à partir d'un signal pseudo sinusoïdal, ainsi que le procédé mis en oeuvre dans un tel système.

Dans la description, on entend par signal pseudo sinusoïdal tout signal qui est sinusoïdal par nature ou dont au moins une portion peut être approximée correctement par une sinusoïde.

En particulier, le système et le procédé suivant l'invention permettent la détermination d'une donnée angulaire, telle que la position ou la vitesse, d'un organe tournant par rapport à un organe fixe.

Le système de détermination comprend un codeur 1 apte à émettre le signal sinusoïdal et un capteur 2 disposé à distance de lecture du codeur 1. Ainsi, comme on le verra dans la suite de la description, en prévoyant que le codeur 1 soit solidaire de l'organe mobile et que le capteur 2 soit solidaire de l'organe fixe, le signal pseudo sinusoïdal délivré par le codeur 1 est représentatif de la donnée angulaire souhaitée.

Dans le mode de réalisation représenté, le codeur 1 est magnétique et comprend un anneau pourvu d'une succession alternée de pôles magnétiques Nord et Sud 1a de longueur polaire constante. De façon connue, ce type de codeur 1 est apte à émettre un signal pseudo sinusoïdal magnétique en fonction du déplacement du codeur 1. Toutefois, d'autre type de codeur et/ou de signal pseudo-sinusoïdal rentrent dans le cadre de l'invention, qu'il soit de nature optique, thermique ou acoustique par exemple.

Le capteur 2 comprend au moins quatre éléments sensibles 3 qui sont linéairement équirépartis, lesdits éléments sensibles étant aptes à délivrer chacun un signal $S_i$ (i = 1 à 4) représentatif du signal émis par le codeur 1 en quatre points virtuels équidistants. Les moyens formant le capteur 2, ainsi qu'éventuellement les dispositifs de traitement des signaux, peuvent être intégrés sur un substrat de sorte à former un circuit intégré et personnalisé pour application spécifique (ASIC).

Dans des exemples de réalisation, les éléments sensibles 3 sont choisis dans le groupe comprenant les sondes à effet Hall, les magnétorésistances, les thermistances, les sondes optiques, les sondes acoustiques.

Le système de détermination comprend en outre un dispositif de traitement qui est apte à former les signaux $S_i$ et à combiner les signaux $S_i$ pour former les signaux :

$$U = (S_1 - S_2) - (S_3 - S_4) \text{ et } V = (S_2 - S_3)$$

Les signaux U et V sont en quadrature quelle que soit la longueur polaire du codeur. Ainsi, pour une large gamme de longueur polaire, il est possible d'exploiter les signaux U et V de façon connue pour déterminer la position ou la vitesse du codeur 1 relativement au capteur 2. Par ailleurs, les signaux U et V peuvent être utilisés pour mesurer l'amplitude du signal pseudo sinusoïdal émis par le codeur 1 puisque les amplitudes des signaux U et V sont proportionnelles à celle du signal émis.

En outre, les signaux U et V étant obtenu par soustraction, ils sont dépourvus d'offset magnétique.

Dans la réalisation selon les figures 1 et 2, le capteur 2 comprend 4N (N=6) éléments sensibles 3 qui sont équirépartis et alignés de sorte à former une barrette de 24 éléments sensibles séparés les uns des autres d'une distance constante δ (voir figure 2). Comme indiqué dans le document FR-A1-2 792 403, l'utilisation d'une barrette d'éléments sensibles 3 permet de conserver les signaux U et V en quadrature pour plusieurs longueurs polaires du codeur 1. En variante, quatre groupes comportant un nombre différent d'éléments sensibles 3 pourraient être utilisé pour obtenir les signaux U et V.

Pour la détermination, quatre groupes 4 de six éléments sensibles 3 adjacents sont utilisés pour sommer les signaux de chaque groupe 4 afin de former quatre signaux $S_i$ correspondant à chacun des groupes. A cet effet, le dispositif de traitement comprend des moyens de sommation des signaux délivrés par chaque groupe 4 de sorte à former les signaux $S_i$.

Sur les figures, un groupe 4 d'éléments sensibles 3 est schématisé par un élément 5 positionné au barycentre du groupe 4, les éléments 5 étant alignés et équirépartis d'une distance $6\delta = d$.

En outre, la barrette est disposée en regard du codeur 1 de sorte que les éléments sensibles 3 s'étendent sensiblement suivant une tangente au rayon de lecture. Toutefois, en cas de faible désalignement de la barrette par rapport à ladite tangente, l'amplitude et la quadrature des signaux U et V s'en trouvent affectées de façon moins importante que suivant l'art antérieur.

Par ailleurs, concernant les amplitudes respectives des signaux U et V, il est possible de prévoir une amplification d'au moins l'un de ces signaux afin de les égaliser. A cet effet, le dispositif de traitement comprend en outre des moyens d'amplification des signaux U et/ou V.

Dans le cas particulier où la distance d est égale au quart de la période spatiale du signal pseudo sinusoïdal à mesurer, c'est-à-dire la moitié de la longueur polaire dans le cas du codeur 1 selon le mode de réalisation représenté, les signaux U et 2V ont la même amplitude. Dans le cas où une telle égalité est nécessaire pour l'utilisation ultérieure des signaux formés, le procédé de détermination prévoit donc d'amplifier le signal V d'un facteur 2. Pour ce faire, le gain d'un amplificateur du dispositif de traitement peut être ajusté à cette valeur.

Si la distance d est quelconque, alors les signaux U et V peuvent être égalisés en amplitude par multiplication par au moins un gain ajusté à cet effet.

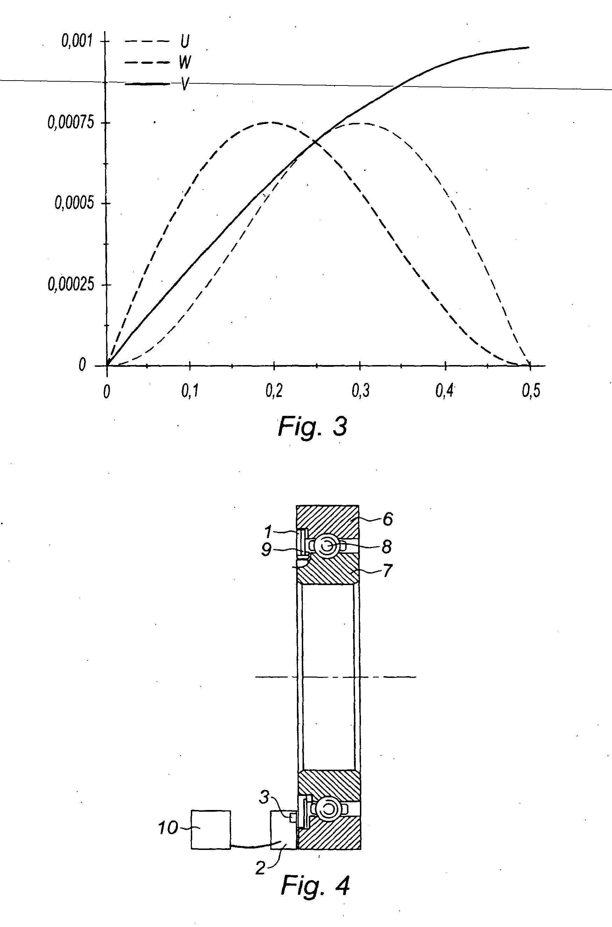

La figure 3 montre que, de part et d'autre du point optimal de fonctionnement (abscisse 0,25 = d / période magnétique), les signaux U et V selon l'invention sont tangents alors que les signaux U et $W = (S_1 + S_2) - (S_3 + S_4)$ selon l'art antérieur se coupent franchement. Par conséquent, en cas de fonctionnement dans un état éloigné du point optimal, par exemple en cas d'excentration du codeur 1, les amplitudes des signaux selon l'invention vont rester proches alors qu'ils vont diverger rapidement selon l'art antérieur.

De même, en cas de tilt du capteur 2, les signaux U et V selon l'invention sont beaucoup moins sensibles relativement à une perte de quadrature que les signaux selon l'art antérieur.

En relation avec la figure 4, on décrit ci-dessous un palier équipé d'un système de détermination selon l'invention. Sur la figure, le palier est sous la forme d'un roulement, sans que cela ne limite l'invention à cette réalisation particulière.

Le roulement comprend une bague extérieure fixe 6, une bague intérieure tournante 7 et des corps roulants 8 disposés entre lesdites bagues pour permettre leur rotation relative.

Le codeur 1 est solidarisé à la bague tournante 7, par exemple par surmoulage sur une armature 9 solidaire de ladite bague, et le capteur 2 est solidaire de la bague fixe 6 de sorte que les éléments sensibles 3 soient disposés à distance de lecture du signal émis par le codeur 1.

En outre, le roulement comprend un dispositif de détermination 10 d'une donnée angulaire de la bague tournante 7 par rapport à la bague fixe 6, ledit dispositif utilisant de façon connue les deux signaux pseudo sinusoïdaux U, V. Par ailleurs, et notamment lorsque les amplitudes des signaux U et V sont les même, le dispositif de détermination peut comprendre des moyens d'interpolation des signaux U et V qui sont aptes à augmenter la résolution de la donnée angulaire.

Parmi les avantages de l'utilisation des signaux U et V selon l'invention on peut citer :

- la quasi insensibilité au tilt du capteur 2 ;
- le peu de sensibilité aux tolérances de placement des éléments sensibles 3 face au codeur 1 ;
- la sensibilité réduite au twist du capteur 2 ;
- la réduction de l'erreur des signaux de sortie dans le cas de l'utilisation d'un interpolateur.


**Revendications**

1. Procédé de détermination de deux signaux pseudo sinusoïdaux en quadrature à partir d'un signal pseudo sinusoïdal émis par un codeur (1), ledit procédé utilisant un capteur (2) disposé à distance de lecture dudit codeur, ledit capteur comprenant au moins quatre éléments sensibles (3) qui sont linéairement équirépartis, lesdits éléments sensibles étant aptes à délivrer chacun un signal $S_i$ représentatif du signal émis par le codeur (1), **caractérisé en ce que** le procédé prévoit de mesurer les signaux $S_i$ et de combiner lesdits signaux $S_i$ pour former les signaux $U = (S_1 - S_2) - (S_3 - S_4)$ et $V = (S_2 - S_3)$, lesdits signaux U et V étant en quadrature.

2. Procédé de détermination selon la revendication 1, **caractérisé en ce qu'**il prévoit une amplification des signaux U et/ou V de sorte à égaliser leur amplitude.

**3.** Procédé de détermination selon la revendication 2, **caractérisé en ce que** le signal V est amplifié d'un facteur 2.

**4.** Procédé de détermination selon l'une quelconque des revendications 1 à 3, ledit procédé prévoyant d'utiliser quatre groupes (4) d'éléments sensibles (3) adjacents, et de sommer les signaux de chaque groupe (4) de sorte à former les signaux $S_i$ correspondant à chacun des groupes (4).

**5.** Système de détermination, par mise en oeuvre d'un procédé selon l'une quelconque des revendications 1 à 4, de deux signaux pseudo sinusoïdaux en quadrature à partir d'un signal pseudo sinusoïdal, ledit système comprenant un codeur (1) apte à émettre le signal et un capteur (2) comprenant au moins quatre éléments sensibles (3) qui sont linéairement équirépartis, lesdits éléments sensibles étant aptes à délivrer chacun un signal $S_i$ représentatif du signal émis par le codeur (1), ledit système comprenant en outre un dispositif de traitement qui est apte à former les signaux $S_i$ et à combiner lesdits signaux $S_i$ pour former les signaux U et V.

**6.** Système de détermination selon la revendication 5, **caractérisé en ce que** le dispositif de traitement comprend en outre des moyens de sommation de signaux délivrés par des éléments sensibles (3) et/ou des moyens d'amplification des signaux U et/ou V.

**7.** Système de détermination selon la revendication 5 ou 6, **caractérisé en ce que** les éléments sensibles (3) sont choisis dans le groupe comprenant les sondes à effet Hall, les magnétorésistances, les thermistances, les sondes optiques, les sondes acoustiques.

**8.** Système de détermination selon l'une quelconque des revendications 5 à 7, **caractérisé en ce que** le codeur (1) comprend un anneau multipolaire délivrant un signal magnétique.

**9.** Palier équipé d'un système de détermination selon l'une quelconque des revendications 5 à 8, ledit palier comprenant un organe fixe (6) et un organe tournant (7), dans lequel le codeur (1) est solidarisé à l'organe tournant (7) et le capteur (2) est solidarisé à l'organe fixe (6) de sorte que les éléments sensibles (3) soient disposés à distance de lecture du signal émis par le codeur (1).

**10.** Palier selon la revendication 9, **caractérisé en ce qu'**il comprend en outre un dispositif de détermination (10) d'une donnée angulaire de l'organe tournant (7) par rapport à l'organe fixe (6), ledit dispositif utilisant les deux signaux pseudo sinusoïdaux en quadrature U, V.

**11.** Palier selon la revendication 10, **caractérisé en ce que** le dispositif de détermination (10) comprend des moyens d'interpolation des signaux U et V qui sont aptes à augmenter la résolution de la donnée angulaire.

**Claims**

**1.** Method for determining two pseudo-sinusoidal signals in quadrature from a pseudo-sinusoidal signal transmitted by an encoder (1), said method using a sensor (2) arranged within reading distance of said encoder, said sensor comprising at least four sensing elements (3) which are linearly equally distributed, said sensing elements being each capable of delivering a signal $S_i$ representative of the signal transmitted by the encoder (1), **characterised in that** it comprises measuring the signals $S_i$ and combining said signals $S_i$ to form the signals $U = (S_1 - S_2) - (S_3 - S_4)$ and $V = (S_2 - S_3)$, said signals U and V being in quadrature.

**2.** Determination method according to claim 1, **characterised in that** it comprises amplifying the signals U and/or V so as to equalise the amplitude thereof.

**3.** Determination method according to claim 2, **characterised in that** the signal V is amplified by a factor of 2.

**4.** Determination method according to any of claims 1 to 3, said method comprising using four groups (4) of adjacent sensing elements (3), and calculating a sum of the signals of each group (4) so as to form the signals $S_i$ corresponding to each of the groups (4).

**5.** Determination system, using a method according to any of claims 1 to 4, of two pseudo-sinusoidal signals in quadrature from a pseudo-sinusoidal signal, said system comprising an encoder (1) capable of transmitting the signal and a sensor (2) including at least four sensing elements (3) which are linearly equally distributed, said sensing elements each being capable of delivering a signal $S_i$ representative of the signal transmitted by the encoder (1), said system further including a processing device capable of forming the signals $S_i$ and combining said signals $S_i$ to form the signals U and V.

6.  Determination system according to claim 5, **characterised in that** the processing device further comprises means for calculating the sum of the signals delivered by sensing elements (3) and/or means for amplifying the signals U and/or V.

7.  Determination system according to claim 5 or 6, **characterised in that** the sensing elements (3) are selected in the group including Hall effect sensors, magnetoresistors, thermistors, optical probes and acoustic probes.

8.  Determination system according to any of claims 5 to 7, **characterised in that** the encoder (1) includes a multipolar ring delivering a magnetic signal.

9.  Bearing equipped with a determination system according to any of claims 5 to 8, said bearing including a stationary member (6) and a rotating member (7), in which the encoder (1) is rigidly connected to the rotating member (7) and the sensor (2) is rigidly connected to the stationary member (6), whereby the sensing elements (3) are arranged within reading distance of the signal transmitted by the encoder (1).

10. Bearing according to claim 9, **characterised in that** it further includes a device (10) angular data of the rotating member (7) in relation to the stationary member (6), said device using the two pseudo-sinusoidal signals in quadrature U, V.

11. Bearing according to claim 10, **characterised in that** the determination device (10) includes for interpolating the signals U and V, which are capable of increasing the resolution of the angular data.


**Patentansprüche**

1.  Verfahren zur Bestimmung von zwei pseudosinusförmigen Quadratursignalen ausgehend von einem pseudosinusförmigen Signal, gesendet von einem Codierer (1), wobei das Verfahren einen Sensor (2) verwendet, der im Lesebereich des Codierers angebracht ist, wobei der Sensor mindestens vier empfindliche Elemente (3) umfasst, die linear gleich verteilt sind, wobei die empfindlichen Elemente dazu geeignet sind, jeweils ein Signal $S_i$ auszugeben, das das Signal, gesendet vom Codierer (1), repräsentiert, **dadurch gekennzeichnet, dass** das Verfahren vorsieht, die Signale $S_i$ zu messen und die Signale $S_i$ zu kombinieren, um die Signale U = $(S_1 - S_2) - (S_3 - S_4)$ und V = $(S_2 - S_3)$ zu bilden, wobei die Signale U und V Quadratursignale sind.

2.  Verfahren zur Bestimmung nach Anspruch 1, **dadurch gekennzeichnet, dass** es eine Verstärkung der Signale U und/oder V vorsieht, um ihre Amplitude auszugleichen.

3.  Verfahren zur Bestimmung nach Anspruch 2, **dadurch gekennzeichnet, dass** das Signal V um einen Faktor 2 verstärkt wird.

4.  Verfahren zur Bestimmung nach einem der Ansprüche 1 bis 3, wobei das Verfahren vorsieht, vier Gruppen (4) von benachbarten empfindlichen Elementen (3) zu verwenden und die Signale jeder Gruppe (4) zu summieren, um die Signale $S_i$ zu bilden, die jeder der Gruppen (4) entsprechen.

5.  System zur Bestimmung, durch die Durchführung eines Verfahrens nach einem der Ansprüche 1 bis 4, von zwei pseudosinusförmigen Quadratursignalen, ausgehend von einem pseudosinusförmigen Signal, wobei das System einen Codierer (1) umfasst, der dazu geeignet ist, das Signal zu senden, und einen Sensor (2), umfassend mindestens vier empfindliche Elemente (3), die linear gleich verteilt sind, wobei die empfindlichen Elemente dazu geeignet sind, jeweils ein Signal $S_i$ auszugeben, das das Signal, gesendet vom Codierer (1), repräsentiert, wobei das System außerdem und Vorrichtung zur Bearbeitung umfasst, die dazu geeignet ist, die Signale $S_i$ zu bilden und die Signale $S_i$ zu kombinieren, um die Signale U und V zu bilden.

6.  System zur Bestimmung nach Anspruch 5, **dadurch gekennzeichnet, dass** die Vorrichtung zur Bearbeitung außerdem Mittel zur Summierung von Signalen umfasst, ausgegeben von empfindlichen Elementen (3), und/oder Mittel zur Verstärkung der Signale U und/oder V.

7. System zur Bestimmung nach Anspruch 5 oder 6, **dadurch gekennzeichnet, dass** die empfindlichen Elemente (3) aus der Gruppe umfassend die Sonden mit Hall-Effekt, die Magnetresistoren, die Thermistoren, die optischen Sonden, die akustischen Sonden, gewählt werden.

8. System zur Bestimmung nach einem der Ansprüche 5 bis 7, **dadurch gekennzeichnet, dass** der Codierer (1) einen mehrpoligen Ring umfasst, der ein magnetisches Signal ausgibt.

9. Lager, ausgestattet mit einem System zur Bestimmung nach einem der Ansprüche 5 bis 8, wobei das Lager ein festes Organ (6) und ein drehendes Organ (7) umfasst, in dem der Codierer (1) mit dem drehenden Organ (7) fest verbunden ist und der Sensor (2) mit dem festen Organ (6) fest verbunden ist, so dass die empfindlichen Elemente (3) im Lesebereich des Signals, gesendet vom Codierer (1), angebracht sind.

10. Lager nach Anspruch 9, **dadurch gekennzeichnet, dass** es außerdem eine Vorrichtung zur Bestimmung (10) eines Winkeldatums des drehenden Organs (7) bezüglich des festen Organs (6) umfasst, wobei die Vorrichtung die zwei pseudosinusförmigen Quadratursignale U, V verwendet.

11. Lager nach Anspruch 10, **dadurch gekennzeichnet, dass** die Vorrichtung zur Bestimmung (10) Mittel zur Interpolation der Signale U und V umfasst, die dazu geeignet sind, die Auflösung des Winkeldatums zu erhöhen.

Fig. 1

Fig. 2

Fig. 3

Fig. 4

**RÉFÉRENCES CITÉES DANS LA DESCRIPTION**

**Documents brevets cités dans la description**

* FR 2792403 A1